# EUROPEAN PATENT APPLICATION

(11) **EP 4 593 219 A1**
(43) Date of publication of application: **30.07.2025**
(21) Application number: 23868102.7
(22) Date of filing: 12.09.2023
(51) Int. Cl.: H01S 5/343, H01S 5/20

(54) **SEMICONDUCTOR LASER ELEMENT**

(30) Priority: 20.09.2022 JP 2022148762; 30.08.2023 JP 2023139787
(71) Applicant: NICHIA CORPORATION, Anan-shi, Tokushima 774-8601 (JP)
(72) Inventor: NAKATSU Yoshitaka, Anan-shi, Tokushima 774-8601 (JP)
(74) Representative: Betten & Resch
(86) International application number: PCT/JP2023/033242
(87) International publication number: WO 2024/062979

(57) **Abstract**

A semiconductor laser element that can reduce a loss of carriers will be provided. The semiconductor laser element includes an n-side semiconductor layer, an active layer, and a p-side semiconductor layer in this order in an upward direction, each of which is made of a nitride semiconductor, in which the p-side semiconductor layer includes a first portion being undoped, an electron barrier layer containing a p-type impurity, and a second portion including one or more p-type semiconductor layers containing a p-type impurity, and the first portion includes a first p-side composition gradient layer made of InₓGa₁₋ₓN and having an In composition ratio x decreasing in a range of 0 to less than 1 upward in the first p-side composition gradient layer, a second p-side composition gradient layer disposed between the first p-side composition gradient layer and the electron barrier layer, made of Al_{y}Ga_{1-y}N, and having an Al composition ratio y increasing in a range of more than 0 to less than 1 upward in the second p-side composition gradient layer, and an intermediate layer disposed between the first p-side composition gradient layer and the second p-side composition gradient layer, made of Al_{z}Ga_{1-z}N, and having an Al composition ratio z in a range of more than 0 to less than y.

## Description

### Technical Field

The present disclosure relates to a semiconductor laser element.

### Background Art

Patent Document 1 discloses a semiconductor laser element including an undoped p-side composition gradient layer and an undoped p-side intermediate layer that are located between an active layer and an electron barrier layer.

### Citation List

### Patent Literature

Patent Document 1: JP 2020-115539 A

### Summary of Invention

### Technical Problem

An object of one aspect of a semiconductor laser element according to the present disclosure is to obtain a semiconductor laser element that can reduce a loss of carriers.

### Solution to Problem

One aspect of a semiconductor laser element according to the present disclosure is a semiconductor laser element including an n-side semiconductor layer, an active layer, and a p-side semiconductor layer, the n-side semiconductor layer, the active layer, and the p-side semiconductor layer being made of a nitride semiconductor, in which the p-side semiconductor layer includes, in this order in an upward direction, a first portion including one or more semiconductor layers and being undoped, an electron barrier layer having a band gap energy larger than a band gap energy of the first portion and containing a p-type impurity, and a second portion including one or more p-type semiconductor layers containing a p-type impurity, and the first portion includes a first p-side composition gradient layer made of InₓGa₁₋ₓN and having an In composition ratio x decreasing in a range of 0 to less than 1 upward in the first p-side composition gradient layer, a second p-side composition gradient layer disposed between the first p-side composition gradient layer and the electron barrier layer, made of Al_{y}Ga_{1-y}N, and having an Al composition ratio y increasing in a range of more than 0 to less than 1 upward in the second p-side composition gradient layer, and an intermediate layer disposed between the first p-side composition gradient layer and the second p-side composition gradient layer, made of Al_{z}Ga_{1-z}N, and having an Al composition ratio z in a range of more than 0 to less than y.

### Advantageous Effects of Invention

A semiconductor laser element that can reduce a loss of carriers can be obtained.

### Brief Description of Drawings

[FIG. 1] FIG. 1 is a schematic cross-sectional view of a semiconductor laser element according to one embodiment of the present invention.
[FIG. 2] FIG. 2 is a view schematically illustrating an example of a layer structure of a p-side semiconductor layer of the semiconductor laser element in FIG. 1.
[FIG. 3] FIG. 3 is a view schematically illustrating an example of a layer structure of an n-side semiconductor layer of the semiconductor laser element in FIG. 1.
[FIG. 4] FIG. 4 is a view schematically illustrating another example of a layer structure of an active layer.
[FIG. 5] FIG. 5 is a partially enlarged view of a first p-side composition gradient layer and its vicinity of the semiconductor laser element in FIG. 1.
[FIG. 6] FIG. 6 is a partially enlarged view of a second p-side composition gradient layer and its vicinity of the semiconductor laser element in FIG. 1.
[FIG. 7] FIG. 7 is a SIMS analysis result of a wafer on which a p-side semiconductor layer similar to that of a first example is grown.
[FIG. 8] FIG. 8 is a graph showing I-L characteristics of semiconductor laser elements of the first example and a first comparative example.
[FIG. 9] FIG. 9 is a graph showing I-L characteristics of semiconductor laser elements of a second example, a third example, and a second comparative example.

### Description of Embodiments

Embodiments of the present invention will be described below with reference to the drawings. The embodiments described below exemplify a method for giving a concrete form to a technical idea of the present invention, and the present invention is not limited to the embodiments described below. Further, in the following description, members having the same terms and reference characters represent the same members or members of the same material, and the detailed description thereof will be omitted as appropriate.

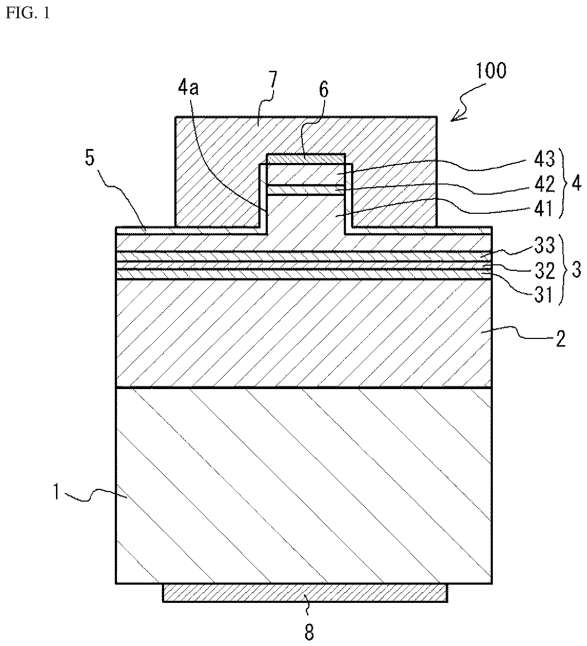

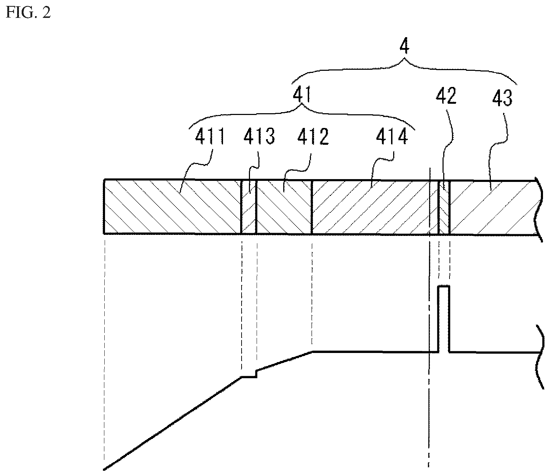

FIG. 1 is a schematic cross-sectional view of a semiconductor laser element 100 according to the present embodiment, which illustrates a cross-section in a direction perpendicular to a resonator direction of the semiconductor laser element 100. FIG. 2 is a view schematically illustrating an example of a layer structure of a p-side semiconductor layer 4 of the semiconductor laser element 100. FIG. 2 schematically illustrates relationship between magnitudes of band gap energies of respective layers. An alternate long and short dash line in FIG. 2 is a line indicating a position of a bottom surface of a ridge 4a. The bottom surface of the ridge 4a refers to a surface connecting the lowermost sides of opposite lateral surfaces of the ridge 4a.

As illustrated in FIG. 1, the semiconductor laser element 100 includes an n-side semiconductor layer 2, an active layer 3, and a p-side semiconductor layer 4 in this order in an upward direction, each of which is made of a nitride semiconductor. In the present specification, a direction from the n-side semiconductor layer 2 toward the p-side semiconductor layer 4 is referred to as up or upward, and a direction opposite thereto is referred to as down or downward. Such up and down directions need not coincide with the direction of gravity when the semiconductor laser element 100 is used.

The p-side semiconductor layer 4 includes a first portion 41, an electron barrier layer 42, and a second portion 43 in this order in an upward direction. The first portion 41 includes one or more semiconductor layers. The first portion 41 is undoped. The electron barrier layer 42 has a band gap energy larger than that of the first portion 41 and contains a p-type impurity. The second portion 43 includes one or more p-type semiconductor layers each containing a p-type impurity. In the present specification, "undoped" means being intentionally not doped. A concentration that does not exceed a detection limit in an analysis result of secondary ion mass spectrometry (SIMS) or the like may be regarded as "undoped". Alternatively, a state in which an impurity concentration is less than 1 × 10¹⁷/cm³ may be regarded as "undoped". For example, when the concentrations of the p-type impurity and the n-type impurity are equal to or lower than the detection limit, the first portion 41 may be regarded as being undoped. However, in a case in which the first portion 41 is in contact with the electron barrier layer 42 having a high p-type impurity concentration, the p-type impurity may be detected in the analysis result even when the first portion 41 is formed without being intentionally doped with the p-type impurity. The concentration of the p-type impurity detected in this case is preferably less than 1 × 10¹⁸/cm³. When the first portion 41 or the like is formed undoped, there is a case in which an unintended impurity such as H or C is contained, and even the state in this case can be also referred to as "undoped". In the present specification, the thickness of a certain layer or portion refers to the shortest distance from a lower surface to an upper surface of the layer or the portion. When the lower surface and/or the upper surface includes a partial recessed portion and/or protruding portion such as a V pit, the shortest distance between flat portions of the lower surface and/or the upper surface having no such recessed portion and/or protruding portion may be a thickness of the layer or the portion. The distance from a certain layer to another layer refers to the shortest distance from the certain layer to the another layer. When the lower surface and/or the upper surface of each of the layers has a partial recessed portion and/or protruding portion such as a V pit, the shortest distance between flat portions of the lower surface and/or the upper surface each having no such recessed portion and/or protruding portion may be a distance between the layers. The relationship of magnitudes of the band gap energies can be determined from compositions of semiconductors to be compared. For example, when two layers to be compared are both made of AlGaN, a layer having a relatively larger Al composition ratio is determined to be a layer having a relatively larger band gap energy.

The first portion 41 includes a first p-side composition gradient layer 411, a second p-side composition gradient layer 412 disposed between the first p-side composition gradient layer 411 and the electron barrier layer 42, and an intermediate layer 413 disposed between the first p-side composition gradient layer 411 and the second p-side composition gradient layer 412. The first p-side composition gradient layer 411 is made of InₓGa₁₋ₓN, and an In composition ratio x decreases in a range of equal to or greater than 0 to less than 1 upward in the first p-side composition gradient layer 411. The second p-side composition gradient layer 412 is made of Al_{y}Ga_{1-y}N, and an Al composition ratio y increases in a range greater than 0 and less than 1 upward in the second p-side composition gradient layer 412. The intermediate layer 413 (first intermediate layer) is made of Al_{z}Ga_{1-z}N, and an Al composition ratio z is greater than 0 and less than y.

By providing the second p-side composition gradient layer 412, the band gap energy can be gradually changed toward the electron barrier layer 42, and an influence of a band spike generated at a heterointerface with difference in a band gap energy can be reduced. The influence of the band spike refers to that electrons are generated by the band spike and thus holes are relatively decreased, causing increase in a loss of carriers. The first p-side composition gradient layer 411 is made of InₓGa₁₋ₓN, and the second p-side composition gradient layer 412 is made of Al_{y}Ga_{1-y}N. Thus, when these layers are grown, source gases are switched during the growing of them. By growing the intermediate layer 413 between these layers, the switched source gases can be stabilized, and the second p-side composition gradient layer 412 can be favorably formed. These layers can be formed by a metal organic chemical vapor deposition (MOCVD) method. By favorably forming the second p-side composition gradient layer 412, the influence of the band spike in the p-side semiconductor layer 4 can be reduced and the loss of carriers can be reduced.

### (Semiconductor Laser Element 100)

As illustrated in FIG. 1, the semiconductor laser element 100 includes a substrate 1, and the n-side semiconductor layer 2, the active layer 3, and the p-side semiconductor layer 4, which are provided above the substrate 1. The semiconductor laser element 100 is an edge-emitting laser element having a light-emitting end surface and a light-reflecting end surface, which intersect a primary surface of a semiconductor layer such as the active layer 3.

For example, the ridge 4a protruding upward is provided in the p-side semiconductor layer 4. The ridge 4a has a mesa structure. A top view shape of the ridge 4a is a shape elongated in a direction connecting the light-emitting end surface and the light-reflecting end surface to each other, and is, for example, a rectangular shape having a short side in a direction parallel to the light-reflecting end surface and a long side in a direction perpendicular to the light-reflecting end surface. A portion of the active layer 3 immediately below the ridge 4a and its vicinity are an optical waveguide region. An insulating film 5 can be provided on a lateral surface of the ridge 4a and on a surface of the p-side semiconductor layer 4 continuous from the lateral surface of the ridge 4a. The substrate 1 is made of, for example, an n-type semiconductor, and an n electrode 8 is provided on the lower surface of the substrate 1. A p electrode 6 is provided in contact with an upper surface of the ridge 4a, and a p-side pad electrode 7 is further provided on the p electrode 6.

The semiconductor laser element 100 can oscillate laser light of, for example, visible light. The semiconductor laser element 100 can oscillate laser light of, for example, blue color or green color. A peak wavelength of the laser light oscillated by the semiconductor laser element 100 is, for example, in a range of 400 nm to 600 nm, and may be in a range of 420 nm to 580 nm, or may be in a range of 500 nm to 580 nm. As the wavelength of the laser light oscillated by the semiconductor laser element 100 increases, light leaking from a light guide layer to the outside increases due to an influence of a wavelength dispersion of a refractive index. As a result, a threshold current increases and a current density at the time of laser oscillation becomes high. As the current density increases, an effective transition interval increases due to screening of localized states and band filling, and an oscillation wavelength shifts to a shorter wavelength. By providing the first p-side composition gradient layer 411, a laser oscillation threshold current density can be reduced, and an effect of inhibiting a short-wavelength shift can be expected. Thus, the peak wavelength of the laser light oscillated by the semiconductor laser element 100 is preferably 500 nm or more, and may be in a range of 500 nm to 580 nm.

### (Substrate 1)

For example, a nitride semiconductor substrate made of GaN or the like can be used as the substrate 1. Examples of the n-side semiconductor layer 2, the active layer 3, and the p-side semiconductor layer 4 each grown on the substrate 1 include semiconductors grown substantially in the c-axis direction. For example, by using a GaN substrate having a +c-plane ((0001) plane) as a primary surface, each semiconductor layer can be grown on the +c-plane of the GaN substrate. Here, having the +c-plane as the primary surface means that the +c-plane may have an off-angle within about ±1 degree. By using the substrate having the +c-plane as the primary surface, an advantage of good mass productivity can be obtained.

### (n-Side Semiconductor Layer 2)

The n-side semiconductor layer 2 can have a multilayer structure made of a nitride semiconductor such as GaN, InGaN, or AlGaN. The n-side semiconductor layer 2 includes one or more n-type semiconductor layers. Examples of the n-type semiconductor layer include a layer made of a nitride semiconductor containing an n-type impurity such as Si or Ge. The n-side semiconductor layer 2 may include an n-side cladding layer and an n-side light guide layer, and may include other layers. The n-side cladding layer has a band gap energy larger than that of the n-side light guide layer. Since the n-type impurity is also a factor of light absorption, which is not as large as the p-type impurity, the n-side light guide layer is preferably undoped or has an n-type impurity concentration lower than an n-type impurity concentration of the n-side cladding layer when the n-side light guide layer contains the n-type impurity.

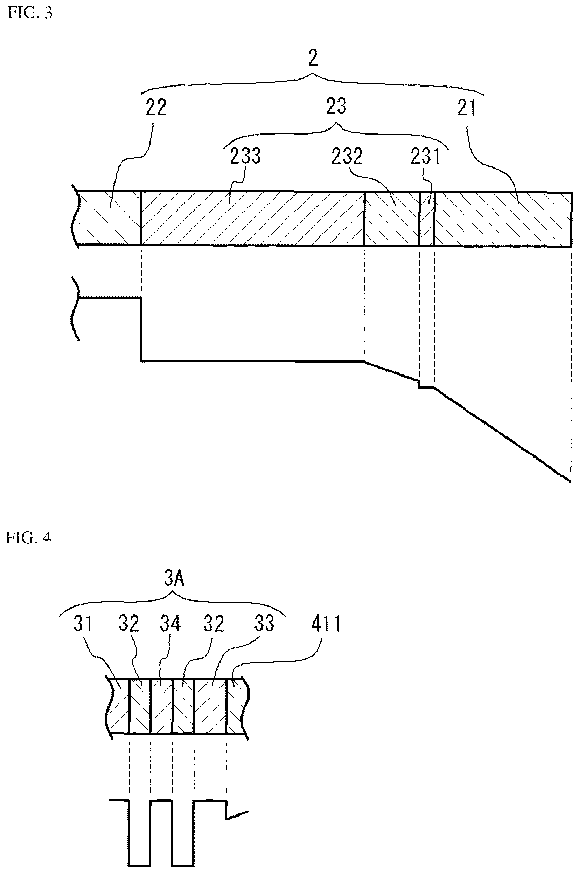

FIG. 3 illustrates an example of a layer structure of the n-side semiconductor layer 2. FIG. 3 is a view schematically illustrating the layer structure of the n-side semiconductor layer 2 of the semiconductor laser element 100. The n-side semiconductor layer 2 may include an n-side composition gradient layer 21 disposed in contact with a lower surface of the active layer 3, an n-type semiconductor layer 22 disposed below the n-side composition gradient layer 21, and an n-side intermediate portion 23 disposed between the n-side composition gradient layer 21 and the n-type semiconductor layer 22. A composition of the n-side composition gradient layer 21 is changed such that the band gap energy increases downward in the n-side composition gradient layer 21. The n-type semiconductor layer 22 contains an n-type impurity and has a band gap energy larger than a band gap energy of any layer included in the first portion 41 of the p-side semiconductor layer 4. A distance from the n-side composition gradient layer 21 to the n-type semiconductor layer 22 is preferably larger than a distance from the first p-side composition gradient layer 411 to the electron barrier layer 42. In that case, an electric field intensity distribution in the semiconductor laser element 100 can be predominant at a side of the n-side semiconductor layer 2, and thus a loss due to light absorption in the electron barrier layer 42 containing the p-type impurity and the layers above the electron barrier layer 42 can be reduced. The n-side semiconductor layer 2 may include a layer other than these layers.

A band gap energy of the n-side composition gradient layer 21 that is closer to the active layer 3 is smaller. A refractive index of the n-side composition gradient layer 21 that is closer to the active layer 3 is higher. Thus, optical confinement in the active layer 3 can be enhanced. The n-side composition gradient layer 21 is, for example, the n-side light guide layer. The n-side composition gradient layer 21 may be a layer made of, for example, InₐGa₁₋ₐN and having an In composition ratio a that increases in a range of 0 to less than 1 upward in the n-side composition gradient layer 21. An average value of the composition gradient layer can be used as a reference for determining a magnitude relationship between the band gap energy or the impurity concentration of the composition gradient layer and that of any of the other layers. The average value of the composition gradient layer refers to a value obtained by dividing a total value of multiplication of the band gap energy or the like and the thickness of each of sublayers constituting the composition gradient layer by a total thickness. When the n-side composition gradient layer 21 is a composition gradient layer in which a lattice constant is increased as a distance from the active layer 3 decreases, an n-type impurity is preferably doped in the composition gradient layer. In other words, it can be said that the composition gradient layer includes a plurality of sublayers having compositions slightly different from each other. Thus, in the composition gradient layer, it is difficult to avoid generation of fixed charges even when a composition change rate thereof is reduced. The fixed charges can be screened by doping the n-type impurity, and thus a degree of voltage increase caused by the generation of the fixed charges can be reduced.

The n-type semiconductor layer 22 is, for example, an n-type AlGaN layer. The n-type semiconductor layer 22 is, for example, an n-side cladding layer. The n-type semiconductor layer 22 and the n-side intermediate portion 23 may be in contact with each other, or another layer may be disposed between the n-type semiconductor layer 22 and the n-side intermediate portion 23. The distance from the n-side composition gradient layer 21 to the n-type semiconductor layer 22 can be less than 600 nm or may be 400 nm or less.

The n-side intermediate portion 23 is a layer having a band gap energy smaller than the band gap energy of the n-type semiconductor layer 22. The n-type impurity concentration of the n-side intermediate portion 23 may be smaller than the n-type impurity concentration of the n-type semiconductor layer 22. The n-side intermediate portion 23 is, for example, an n-type GaN layer containing an n-type impurity.

The n-side intermediate portion 23 may include a composition gradient layer 232 in which the band gap energy is reduced as a distance from the active layer 3 decreases. A band gap energy at a lower end of the composition gradient layer is smaller than the band gap energy of the n-type semiconductor layer 22, and a band gap energy at an upper end of the composition gradient layer is equal to or larger than the band gap energy at the lower end of the n-side composition gradient layer 21. The n-side intermediate portion 23 may include the composition gradient layer 232 and an intermediate layer 233 in order from the n-side composition gradient layer 21 side. The n-side intermediate portion 23 may include an intermediate layer 231, the composition gradient layer 232, and the intermediate layer 233 in order from the n-side composition gradient layer 21 side. The intermediate layer 231 and the intermediate layer 233 are not composition gradient layers, or are composition gradient layers each having a composition change rate smaller than a composition change rate of the composition gradient layer 232. Similarly to the n-side composition gradient layer 21, the composition gradient layer 232 is preferably doped with an n-type impurity. Thus, the degree of voltage increase caused by the generation of the fixed charges can be reduced. The intermediate layers 231 and 233 may be undoped, but each contain, for example, an n-type impurity. The thickness of the n-side intermediate portion 23 may be 100 nm or more. Thus, light leakage toward the n-type semiconductor layer 22 can be reduced. The thickness of the n-side intermediate portion 23 may be 400 nm or less. Thus, the optical confinement in the active layer 3 can be improved.

### (Active Layer 3)

The active layer 3 can have a multilayer structure including a nitride semiconductor layer of GaN, InGaN, or the like. The active layer 3 has a single quantum well structure or a multiple quantum well structure. For example, the active layer 3 includes an n-side barrier layer 31, a well layer 32, and a p-side barrier layer 33 in this order from the n-side semiconductor layer 2 side. When the active layer 3 has a multiple quantum well structure, the active layer 3 includes a plurality of well layers 32 and intermediate barrier layers each located between corresponding ones of the well layers 32.

A distance from the well layer 32 closest to the n-side semiconductor layer 2 to the lower surface of the active layer 3 can be, for example, 10 nm or less. The distance from the well layer 32 closest to the n-side semiconductor layer 2 to the lower surface of the active layer 3 may be 0 nm, that is, a lower surface of the well layer 32 may be the lower surface of the active layer 3. When the n-side semiconductor layer 2 includes the n-side composition gradient layer 21, a layer having a band gap energy larger than a band gap energy at an upper end of the n-side composition gradient layer 21 is preferably disposed as at least a part of the n-side barrier layer 31. Thus, a probability of radiative recombination in the well layer 32 can be raised. The n-side barrier layer 31 is disposed between the well layer 32 closest to the n-side semiconductor layer 2 and the n-side composition gradient layer 21. The distance from the well layer 32 closest to the n-side semiconductor layer 2 to the lower surface of the active layer 3 may be 1 nm or more, or may be in a range of 1 nm to 10 nm.

A distance from the well layer 32 closest to the p-side semiconductor layer 4 to an upper surface of the active layer 3 can be, for example, 5 nm or less. A layer having a band gap energy larger than a band gap energy at a lower end of the first p-side composition gradient layer 411 is preferably disposed as at least a part of the p-side barrier layer 33. Thus, the probability of radiative recombination in the well layer 32 can be raised. The p-side barrier layer 33 is disposed between the well layer 32 closest to the p-side semiconductor layer 4 and the p-side semiconductor layer 4. The distance from the well layer 32 closest to the p-side semiconductor layer 4 to the upper surface of the active layer 3 may be 1 nm or more, or may be in a range of 1 nm to 5 nm. The active layer 3 is preferably formed without being doped with a p-type impurity. Thus, light absorption loss caused by the doping of the p-type impurity can be reduced. Each layer of the active layer 3 is, for example, an undoped layer.

The well layer 32 is, for example, an InₓGa₁₋ₓN well layer. When the semiconductor laser element has an oscillation wavelength of 500 nm or more, an In composition ratio x of the InₓGa₁₋ₓN well layer is, for example, 0.23 or more although the ratio slightly increases or decreases depending on the layer structure other than the active layer 3. The upper limit of the In composition ratio x of the well layer 32 is ,for example, 0.50 or less. In this case, the oscillation wavelength of the semiconductor laser element is considered to be about 600 nm or less.

Another example of the active layer is illustrated in FIG. 4. FIG. 4 is a view schematically illustrating another example of the layer structure of the active layer. An active layer 3A illustrated in FIG. 4 includes an n-side barrier layer 31, a plurality of well layers 32, an intermediate barrier layer 34, and a p-side barrier layer 33. The plurality of well layers 32 are located between the n-side barrier layer 31 and the p-side barrier layer 33. The plurality of well layers 32 include a first well layer and a second well layer. The first well layer and the second well layer are located between the n-side barrier layer 31 and the p-side barrier layer 33. The intermediate barrier layer 34 is a layer located between two well layers 32. The intermediate barrier layer 34 is located between the first well layer and the second well layer. The number of the well layers 32 is plural, for example, two. Band gap energies of the n-side barrier layer 31, the intermediate barrier layer 34, and the p-side barrier layer 33 are each larger than a band gap energy of the well layer 32. Examples of the thicknesses of the plurality of well layers 32 include a range of 1 nm to 4 nm. The plurality of well layers 32 may have the same thickness.

As a thickness of the intermediate barrier layer 34 is reduced, a drive voltage of the semiconductor laser element 100 tends to be reduced. On the other hand, the p-side barrier layer 33 preferably has a certain thickness as a foundation layer before the p-side semiconductor layer 4 is layered, for the purpose of restoring crystallinity. Thus, the thickness of the intermediate barrier layer 34 is preferably thinner than the thickness of the p-side barrier layer 33. This structure allows for achieving both a reduction in the drive voltage of the semiconductor laser element 100 and an improvement in the crystallinity of the p-side semiconductor layer 4. The crystallinity can be evaluated by, for example, a dislocation density. The thickness of each layer refers to a thickness in the layering direction. The intermediate barrier layer 34 is, for example, an undoped GaN layer. The thickness of the intermediate barrier layer 34 is preferably 3 nm or less and more preferably 2.5 nm or less. This structure allows for improving efficiency of electron injection into the well layer 32. The thickness of the intermediate barrier layer 34 can be 1 nm or more, and is preferably 1.5 nm or more and more preferably 2 nm or more. When the thickness of the intermediate barrier layer 34 is 1.5 nm or more, a decrease in efficiency of carrier confinement can be inhibited and a decrease in the power of the semiconductor laser element 100 can be inhibited. The thickness of the intermediate barrier layer 34 can be in a range of 1 nm to 3 nm, and is preferably in a range of 1.5 nm to 3 nm and more preferably in a range of 1.5 nm to 2.5 nm. The thickness of the intermediate barrier layer 34 may be in a range of 2 nm to 2.5 nm.

The thickness of the p-side barrier layer 33 may be larger than the thickness of a single well layer 32. The thickness of the p-side barrier layer 33 is preferably 2.5 nm or more. In that case, the crystallinity of the p-side semiconductor layer 4 can be further effectively improved. When the thickness of the p-side barrier layer 33 is large to some extent, the drive voltage of the semiconductor laser element 100 increases. The thickness of the p-side barrier layer 33 is preferably 7 nm or less. In that case, increase in the drive voltage of the semiconductor laser element 100 can be inhibited. The thickness of the p-side barrier layer 33 is preferably in a range of 2.5 nm to 7 nm. The thickness of the p-side barrier layer 33 may be larger than 2.5 nm. The thickness of the p-side barrier layer 33 may be more than 2.5 nm and 7 nm or less. The p-side barrier layer 33 is preferably a GaN layer and more preferably an undoped GaN layer. In that case, the crystallinity of the p-side semiconductor layer 4 can be further effectively improved.

The semiconductor laser element 100 including the active layer 3A may include the n-side semiconductor layer 2, the active layer 3, and the p-side semiconductor layer 4 in this order in an upward direction, each of which is made of a nitride semiconductor. The active layer 3A may include the n-side barrier layer 31, the p-side barrier layer 33, the plurality of well layers 32 located between the n-side barrier layer 31 and the p-side barrier layer 33 and including the first well layer and the second well layer, and the intermediate barrier layer 34 located between the first well layer and the second well layer. The thickness of the intermediate barrier layer 34 is thinner than the thickness of the p-side barrier layer 33. The p-side semiconductor layer 4 in this case includes one or more semiconductor layers, and may include the first portion 41 that is undoped, the electron barrier layer 42 that has a band gap energy larger than that of the first portion 41 and contains the p-type impurity, and the second portion 43 that includes one or more p-type semiconductor layers each containing the p-type impurity, in this order in an upward direction. The p-side semiconductor layer 4 in this case may include the first p-side composition gradient layer 411. The p-side semiconductor layer 4 in this case need not include the second p-side composition gradient layer 412 and the intermediate layer 413.

### (p-Side Semiconductor Layer 4)

The p-side semiconductor layer 4 can have a multilayer structure formed using a nitride semiconductor such as GaN, InGaN, or AlGaN. The p-side semiconductor layer 4 can include a p-side cladding layer and a p-side light guide layer, and may include a layer other than these layers. In a case in which a transparent conductive film is provided as the p electrode 6, the transparent conductive film can function as the cladding layer, and thus the cladding layer need not be provided in the p-side semiconductor layer 4. The p-side semiconductor layer 4 includes one or more p-type semiconductor layers. Examples of the p-type semiconductor layer include a layer made of a nitride semiconductor containing a p-type impurity such as Mg. Because the activation rate of the p-type impurity is lower than the activation rate of an n-type impurity such as Si, it is necessary to dope the p-type semiconductor layer with the p-type impurity at a higher concentration in order to obtain sufficient injection of holes, and a free carrier absorption loss due to the p-type impurity increases.

### (First Portion 41)

The first portion 41 is a portion of the p-side semiconductor layer 4, which connects between the active layer 3 and a p-type impurity-containing layer. The first portion 41 may be disposed in contact with the upper surface of the active layer 3. The first portion 41 is a portion not containing the p-type semiconductor layer. A layer containing a p-type impurity may be included in a part of the first portion 41 as long as the p-type impurity concentration and the thickness do not affect the free carrier absorption loss. However, when Mg necessary for p-type doping is doped, a p-type impurity of about 1 × 10¹⁸/cm³ or more is required, and in this case, there is a high possibility that the free carrier absorption loss increases. Thus, the first portion 41 is preferably a portion that does not include the p-type semiconductor layer. The first portion 41 preferably has a low p-type impurity concentration to such an extent that the p-type impurity concentration measured by analysis such as SIMS is the detection limit or less over the entire first portion 41. For example, the first portion 41 is formed without being intentionally doped with the p-type impurity over the entire first portion 41 at the time of manufacture. The first portion 41 can be formed so as to be undoped over the entire first portion 41. As the thickness of the first portion 41 is increased, light leaking to the second portion 43 can be reduced, and thus the thickness of the first portion 41 is preferably 400 nm or more. An upper limit value of the thickness of the first portion 41 can be such an extent that supply of holes from the second portion 43 is not hindered. The greater the thickness of the first portion 41, the greater the number of overflowing electrons tends to be. Thus, from this viewpoint, it can be said that, the smaller the thickness of the first portion 41, the lower the probability of occurrence of overflow of electrons can be. From this viewpoint, the thickness of the first portion 41 can be, for example, 660 nm or less. With a band gap difference between the first portion 41 and the electron barrier layer 42, the probability of the occurrence of the overflow of electrons can be reduced. Thus, the layer of the first portion 41 in contact with the electron barrier layer 42 is preferably a layer having a band gap energy smaller than the band gap energy of the electron barrier layer 42.

When the first portion 41 is a portion that is not undoped but lightly doped, the first portion 41 preferably has a p-type impurity concentration lower than the p-type impurity concentration of the electron barrier layer 42, over the entire first portion 41, and more preferably has a p-type impurity concentration lower than both the p-type impurity concentrations of the electron barrier layer 42 and the second portion 43. The n-type impurity concentration of the first portion 41 may be less than 2 × 10¹⁸/cm³. Preferably, the first portion 41 has a low n-type impurity concentration to such an extent that the n-type impurity is not detected by SIMS analysis (i.e., at a background level). In other words, the first portion 41 preferably does not substantially contain the n-type impurity.

A lower end of the ridge 4a is preferably located in the first portion 41. Thus, the lower end of the ridge 4a can be closer to the active layer 3. For example, the ridge 4a includes a part of the first portion 41, the electron barrier layer 42, and the second portion 43.

### (First p-Side Composition Gradient Layer 411)

The first p-side composition gradient layer 411 is a layer in which the band gap energy is increased upward in the first p-side composition gradient layer 411. Such a configuration can enhance the optical confinement in the active layer 3. The first p-side composition gradient layer 411 can be in contact with the active layer 3. With the first p-side composition gradient layer 411 located near the active layer 3, the optical confinement effect by the first p-side composition gradient layer 411 can be improved. The first p-side composition gradient layer 411 can be in contact with the second p-side composition gradient layer 412. A distance from the first p-side composition gradient layer 411 to the electron barrier layer may be 150 nm or more. The distance from the first p-side composition gradient layer 411 to the electron barrier layer may be 600 nm or less. Enhancement of the optical confinement in the active layer 3 by the first p-side composition gradient layer 411 allows for reducing the laser oscillation threshold current density. As a result, the screening of the localized state can be inhibited, and a short-wavelength shift of the oscillation wavelength due to an increase in current injection can be inhibited, which is advantageous for increasing the oscillation wavelength.

The first p-side composition gradient layer 411 includes an upper surface and a lower surface, and the band gap energy of the first p-side composition gradient layer 411 increases from the lower surface toward the upper surface. A band gap energy on a lower surface side of the first p-side composition gradient layer 411 is smaller than a band gap energy on an upper surface side of the first p-side composition gradient layer 411. Although the first p-side composition gradient layer 411 is illustrated in a slope shape in FIG. 2, it can be said that the composition gradient layer is an aggregate of the plurality of sublayers having compositions different from each other as described later. Thus, it can be regarded that in the first p-side composition gradient layer 411, the band gap energy increases stepwise from the lower surface toward the upper surface. The n-side composition gradient layer 21 paired with the first p-side composition gradient layer 411 may be provided in the n-side semiconductor layer 2. For example, in the band gap energy structure, the first p-side composition gradient layer 411 and the n-side composition gradient layer can be formed so as to be symmetrical across the active layer 3.

The first p-side composition gradient layer 411 functions as, for example, the p-side light guide layer. The thickness of the first p-side composition gradient layer 411 is thicker than that of the well layer included in the active layer 3, and is thicker than that of the p-side barrier layer 33 when the p-side barrier layer 33 is present. In order to improve the optical confinement effect, the thickness of the first p-side composition gradient layer 411 is preferably 100 nm or more. The thickness of the first p-side composition gradient layer 411 can be 500 nm or less. The thickness of the first p-side composition gradient layer 411 may be 200 nm or less. When the p-side barrier layer 33 is provided, the band gap energy at the lower end of the first p-side composition gradient layer 411 is preferably smaller than the band gap energy of the p-side barrier layer 33. A band gap energy at an upper end of the first p-side composition gradient layer 411 may be equal to or larger than the band gap energy of the p-side barrier layer 33.

The first p-side composition gradient layer 411 has a structure in which a refractive index decreases from the active layer 3 side toward the electron barrier layer 42 side, and the band gap energy increases from the active layer 3 side toward the electron barrier layer 42 side. Thus, the overflow of electrons can be inhibited while light is brought closer to the active layer 3. A composition of the first p-side composition gradient layer 411 is changed at a first change rate so that the band gap energy is increased upward in the first p-side composition gradient layer 411.
The first change rate is a change rate of the band gap energy, and may be obtained by calculation from a change rate of the In composition ratio x. For example, the In contents of the first p-side composition gradient layer 411 obtained by analysis such as SIMS are plotted in a table, and a slope thereof can be used as the change rate of the In composition ratio x. The In contents obtained by the analysis may be plotted in a table on a linear scale, a linear approximate curve may be created from the table, and a slope of the approximate curve may be used as the change rate of the In composition ratio x.

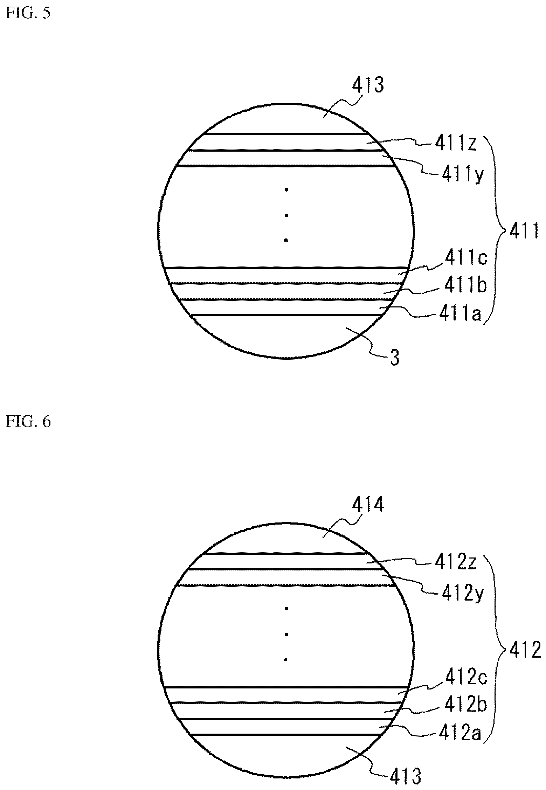

As illustrated in FIG. 5, it can be said that the first p-side composition gradient layer 411 includes a plurality of sublayers 411a, 411b, 411c, 411y, and 411z having compositions different from each other. FIG. 5 is a partially enlarged view of the first p-side composition gradient layer 411 and its vicinity, and a plurality of sublayers other than the sublayer 411c and the sublayer 411y are present between the sublayer 411c and the sublayer 411y. When the first p-side composition gradient layer 411 is made of InₓGa₁₋ₓN, a relationship between an In composition ratio xₐ of a lowermost sublayer 411a and an In composition ratio x_{z} of an uppermost sublayer 411z of the first p-side composition gradient layer 411 is 0 ≤ x_{z} < xₐ. An upper limit value of the In composition ratio xₐ of the sublayer 411a constituting the lower end of the first p-side composition gradient layer 411 is, for example, 0.25. In consideration of inhibition of deterioration of crystallinity, the In composition ratio xₐ is preferably 0.1 or less.

A difference in lattice constant between adjacent ones of the sublayers is preferably small. Thus, distortion can be reduced. Thus, the first p-side composition gradient layer 411 is preferably changed little by little in composition with a small thickness. To be more specific, the In composition ratio x of the first p-side composition gradient layer 411 preferably decreases from the lower surface to the upper surface at every thickness of 25 nm or less. That is, the thickness of each of the sublayers 411a, 411b, 411c, 411y, and 411z is preferably 25 nm or less. The thickness of each of the sublayers 411a, 411b, 411c, 411y, and 411z is more preferably 20 nm or less, may be 10 nm or less, and may be 5 nm or less. A lower limit value of the thickness of each of the sublayers 411a, 411b, 411c, 411y, and 411z is, for example, about one atomic layer (about 0.25 nm). A difference in the In composition ratio x between adjacent ones of the sublayers (for example, the sublayer 411a and the sublayer 411b) is preferably 0.005 or less and more preferably 0.001 or less. A lower limit value of the difference in the In composition ratio x between adjacent ones of the sublayers is, for example, about 0.00007. Such a range is preferably satisfied over the entire first p-side composition gradient layer 411. That is, such a range is preferably satisfied for all the sublayers. The number of times the composition is changed in the first p-side composition gradient layer 411, that is, the number of the sublayers of the first p-side composition gradient layer 411 is preferably 90 or more.

When the n-side composition gradient layer 21 is provided, preferable ranges of the composition, the composition change rate, and the thickness of the n-side composition gradient layer 21 may be similar to those of the first p-side composition gradient layer 411.

### (Second p-Side Composition Gradient Layer 412)

The second p-side composition gradient layer 412 is disposed between the first p-side composition gradient layer 411 and the electron barrier layer 42. The second p-side composition gradient layer 412 has an upper surface and a lower surface, and the band gap energy of the second p-side composition gradient layer 412 is increased from the lower surface toward the upper surface. A band gap energy on a lower surface side of the second p-side composition gradient layer 412 is smaller than a band gap energy on an upper surface side of the second p-side composition gradient layer 412. Similarly to the first p-side composition gradient layer 411, it can be said that the composition gradient layer is an aggregate of the plurality of sublayers having compositions different from each other, and thus it can be said that in the second p-side composition gradient layer 412, the band gap energy increases stepwise from the lower surface toward the upper surface.

The thickness of the second p-side composition gradient layer 412 can be 2 nm or more. Thus, the band spike can be effectively reduced. The thickness of the second p-side composition gradient layer 412 may be 10 nm or more, and may be 50 nm or more. Thus, light leakage to the electron barrier layer 42 and the second portion 43 can be reduced, and absorption loss of light can be reduced. The thickness of the second p-side composition gradient layer 412 may be thicker than the thickness of the well layer included in the active layer 3. When the p-side barrier layer 33 is present, the thickness of the second p-side composition gradient layer 412 may be thicker than the thickness of the p-side barrier layer 33. The thickness of the second p-side composition gradient layer 412 is preferably 250 nm or less, may be 200 nm or less, and may be 100 nm or less. The thickness of the second p-side composition gradient layer 412 may be in a range of 2 nm to 250 nm, and may be in a range of 10 nm to 250 nm.

The band gap energy at the lower end of the second p-side composition gradient layer 412 is larger than the band gap energy at the upper end of the first p-side composition gradient layer 411. A band gap energy at an upper end of the second p-side composition gradient layer 412 is smaller than the band gap energy of the electron barrier layer 42. The band gap energy at the upper end of the second p-side composition gradient layer 412 may be larger than a band gap energy of a layer constituting a lower end of the second portion 43. The Al composition ratio y at the lower end of the second p-side composition gradient layer 412 is preferably in a range of more than the Al composition ratio z of the intermediate layer 413 to 0.05. Thus, the second p-side composition gradient layer 412 made of AlGaN can be easily stably formed. The Al composition ratio y at the upper end of the second p-side composition gradient layer 412 is preferably 0.1 or less. Thus, the influence of the band spike can be easily reduced.

The second p-side composition gradient layer 412 has a structure in which a refractive index decreases from the active layer 3 side toward the electron barrier layer 42 side, and the band gap energy increases from the active layer 3 side toward the electron barrier layer 42 side. A composition of the second p-side composition gradient layer 412 is changed at a second change rate lower than the first change rate such that the band gap energy is increased upward in the second p-side composition gradient layer 412. Thus, the influence of the band spike can be easily reduced. The second change rate can be obtained in a manner similar to that of the first change rate. That is, the second change rate is a change rate of the band gap energy, and may be obtained by calculation from a change rate of the Al composition ratio y. The Al contents of the second p-side composition gradient layer 412 obtained by analysis such as SIMS are plotted in a table, and a slope thereof can be used as the change rate of the Al composition ratio y. The Al contents obtained by the analysis may be plotted in a table on a linear scale, a linear approximate curve may be created from the table, and a slope of the approximate curve may be used as the change rate of the Al composition ratio y. Even when at least one of the In content of the first p-side composition gradient layer 411 and the Al content of the second p-side composition gradient layer 412 is changed nonlinearly in the layer, a magnitude relationship between the first change rate and the second change rate can be compared by creating a linear approximate curve of the nonlinear change.

As illustrated in FIG. 6, it can be said that the second p-side composition gradient layer 412 is constituted of a plurality of sublayers 412a, 412b, 412c, 412y, and 412z having compositions different from each other. FIG. 6 is a partially enlarged view of the second p-side composition gradient layer 412 and its vicinity, and a plurality of sublayers other than the sublayer 412c and the sublayer 412y are present between the sublayer 412c and the sublayer 412y. When the second p-side composition gradient layer 412 is made of Al_{y}Ga_{1-y}N, a relationship between an Al composition ratio yₐ of a lowermost sublayer 412a and an Al composition ratio y_{z} of an uppermost sublayer 412z of the second p-side composition gradient layer 412 is yₐ < y_{z} < 1. The Al composition ratio yₐ of the sublayer 412a constituting the lower end of the second p-side composition gradient layer 412 can be z < yₐ ≤ 0.05. Z is the Al composition ratio of the intermediate layer 413. The Al composition ratio y_{z} of the sublayer 412z constituting the upper end of the second p-side composition gradient layer 412 can be yₐ < y_{z} ≤ 0.1.

The Al composition ratio y of the second p-side composition gradient layer 412 preferably increases from the lower surface to the upper surface at every thickness of 25 nm or less. That is, the thickness of each of the sublayers 412a, 412b, 412c, 412y, and 412z is preferably 25 nm or less. Thus, distortion generated between adjacent ones of the sublayers can be reduced. The thickness of each of the sublayers 412a, 412b, 412c, 412y, and 412z is more preferably 20 nm or less, may be 10 nm or less, and may be 5 nm or less. A lower limit value of the thickness of each of the sublayers 412a, 412b, 412c, 412y, and 412z is, for example, about one atomic layer (about 0.25 nm). A difference in the Al composition ratio y between adjacent ones of the sublayers (for example, the sublayer 412a and the sublayer 412b) is preferably 0.005 or less, and more preferably 0.001 or less. A lower limit value of the difference in the Al composition ratio y between adjacent ones of the sublayers is, for example, about 0.00007. Such a range is preferably satisfied over the entire second p-side composition gradient layer 412. That is, such a range is preferably satisfied for all the sublayers. The number of times the composition changed in the second p-side composition gradient layer 412, that is, the number of the sublayers of the second p-side composition gradient layer 412 is preferably 10 or more, and more preferably 30 or more.

When the composition gradient layer 232 is provided in the n-side intermediate portion 23, preferable ranges of the composition, the composition change rate, and the thickness thereof may be similar to those of the second p-side composition gradient layer 412.

### (Intermediate Layer 413)

The intermediate layer 413 is disposed between the first p-side composition gradient layer 411 and the second p-side composition gradient layer 412. The intermediate layer 413 is in contact with the second p-side composition gradient layer 412. The intermediate layer 413 may be in contact with the first p-side composition gradient layer 411.

The intermediate layer 413 is made of Al_{z}Ga_{1-z}N. The Al composition ratio z of the intermediate layer 413 is less than the Al composition ratio y of the second p-side composition gradient layer 412. The Al composition ratio y of the second p-side composition gradient layer 412 is not constant, but the Al composition ratio z of the intermediate layer 413 is lower than any value of the Al composition ratio y. Since the minimum Al composition ratio y in the second p-side composition gradient layer 412 is the Al composition ratio y at the lower end, the Al composition ratio y at the lower end of the second p-side composition gradient layer 412 may be compared with the Al composition ratio z of the intermediate layer 413. The Al composition ratio z of the intermediate layer 413 can be in a range more than 0 and equal to or less than 0.01. Such a low Al composition ratio z is suitable for stable formation of the second p-side composition gradient layer 412. The Al composition ratio z of the intermediate layer 413 may be in a range more than 0 and less than 0.01 or may be in a range more than 0 and equal to or less than 0.005. The intermediate layer 413 is not a composition gradient layer, or is a composition gradient layer having a composition change rate lower than a composition change rate of the second p-side composition gradient layer 412. For example, a change in Al composition per 1 nm of the intermediate layer 413 may be 0.0001 or less. When the composition of the intermediate layer 413 is not constant, the median value thereof is taken as the Al composition ratio z.

The thickness of the intermediate layer 413 can be 2 nm or more, and may be 10 nm or more and may be 50 nm or more. Thus, the second p-side composition gradient layer 412 can be easily stably formed. The thickness of the intermediate layer 413 can be 250 nm or less, may be 200 nm or less, and may be 100 nm or less. Thus, the first portion 41 including the intermediate layer 413 can be efficiently formed. The thickness of the intermediate layer 413 can be in a range of 0.5 times to 1.5 times of the thickness of the second p-side composition gradient layer 412.

When the intermediate layer 231 is provided in the n-side intermediate portion 23, preferable ranges of the composition, the composition change rate, and the thickness thereof may be similar to those of the intermediate layer 413.

### (Intermediate Layer 414)

The second p-side composition gradient layer 412 may be in contact with the electron barrier layer 42, but the intermediate layer 414 may be disposed between the second p-side composition gradient layer 412 and the electron barrier layer 42. The intermediate layer 413 and the intermediate layer 414 may be referred to as a first intermediate layer and a second intermediate layer, respectively. The intermediate layer 414 may be in contact with the second p-side composition gradient layer 412 and the electron barrier layer 42.

The band gap energy of the intermediate layer 414 has the same value as the band gap energy at the upper end of the second p-side composition gradient layer 412, or has a value between the band gap energy at the upper end of the second p-side composition gradient layer 412 and the band gap energy of the electron barrier layer 42. By disposing such an intermediate layer 414, the optical confinement in the active layer 3 can be improved. By providing the intermediate layer 414, the electron barrier layer 42 and the second portion 43 each containing the p-type impurity can be located further away from the active layer 3, and thus the absorption loss of light can be reduced. By reducing the absorption loss of light, the efficiency of the semiconductor laser element 100 can be improved. Examples of the efficiency of the semiconductor laser element 100 include slope efficiency, which is a slope in a characteristic graph of current and optical output at a current value of a threshold current or more.

The intermediate layer 414 is not a composition gradient layer, or is composition gradient layer having a composition change rate lower than a composition change rate of the second p-side composition gradient layer 412. For example, a change in Al composition per 1 nm of the intermediate layer 414 may be 0.001 or less. When the composition of the intermediate layer 414 is not constant, the median value thereof may be used as the composition of the intermediate layer 414 and the magnitude of the band gap energy may be compared with those of the other layers. The lower end of the ridge 4a is preferably located in the intermediate layer 414. In that case, as compared with the case in which the lower end of the ridge 4a is located in the composition gradient layer, variation in an effective refractive index difference between the inside and the outside of the ridge 4a due to variation in the depth of the ridge 4a can be reduced.

For example, the intermediate layer 414 is made of AlGaN. When a lower surface of the intermediate layer 414 is in contact with the upper surface of the second p-side composition gradient layer 412, a lattice constant at the lower end of the intermediate layer 414 is preferably the same as a lattice constant at the upper end of the second p-side composition gradient layer 412. The smaller the difference between the lattice constant of the intermediate layer 414 and the lattice constant of the upper end of the second p-side composition gradient layer 412 is, the more the influence of the band spike can be reduced. When the intermediate layer 414 is made of AlGaN, the difference between the maximum Al composition ratio in the intermediate layer 414 and the Al composition ratio y at the upper end of the second p-side composition gradient layer 412 is preferably 0.02 or less and more preferably 0.01 or less. Thus, the influence of the band spike can be reduced.

The thickness of the intermediate layer 414 is thicker than a sublayer constituting the second p-side composition gradient layer 412. The thickness of the intermediate layer 414 may be thicker than 25 nm, and may be 50 nm or more. The thickness of the intermediate layer 414 may be 600 nm or less, and may be 250 nm or less.

A sum of the thickness of the second p-side composition gradient layer 412 and the thickness of the intermediate layer 414 is preferably 100 nm or more. Thus, light leakage to the electron barrier layer 42 and the second portion 43 can be reduced, and absorption loss of light can be reduced. The sum of the thickness of the second p-side composition gradient layer 412 and the thickness of the intermediate layer 414 is preferably 500 nm or less. In that case, the electron barrier layer 42 can be disposed at a position not too far from the active layer 3, and thus the total amount of the overflow of electrons to the second portion 43 can be reduced. A ratio of the thickness of the second p-side composition gradient layer 412 to the sum of the thickness of the second p-side composition gradient layer 412 and the thickness of the intermediate layer 414 is preferably 0.5 or less. The average value of the band gap energy of the second p-side composition gradient layer 412 is smaller than the band gap energy of the intermediate layer 414, and thus the more the thickness of the second p-side composition gradient layer 412 is increased, the more the optical confinement in the active layer 3 is reduced. Thus, with the second p-side composition gradient layer 412 having a relatively small thickness, the optical confinement in the active layer 3 can be improved. Thus, a reduction in the oscillation threshold current of the semiconductor laser element 100 can be expected. The amount of light reaching the second portion 43 can be reduced, and thus the absorption loss of light can be reduced and the optical output can be increased.

When the intermediate layer 233 is provided in the n-side intermediate portion 23, preferable ranges of the composition, the composition change rate, and the thickness thereof may be similar to those of the intermediate layer 414.

### (Electron Barrier Layer 42)

The electron barrier layer 42 contains a p-type impurity such as Mg. The electron barrier layer 42 may be disposed in contact with an upper surface of the first portion 41. The band gap energy of the electron barrier layer 42 is larger than the band gap energy of the first portion 41. When the first portion 41 has the multilayer structure as described above, the electron barrier layer 42 is a layer having a band gap energy larger than that of any layer included in the first portion 41. When the electron barrier layer 42 is a layer having such a large band gap energy, the electron barrier layer 42 can function as a barrier against electrons overflowing from the active layer 3. A band gap energy difference between the electron barrier layer 42 and an uppermost layer of the first portion 41 is preferably 0.1 eV or more. The band gap energy difference can be, for example, 1 eV or less.
The electron barrier layer 42 is, for example, a layer having the highest band gap energy in the p-side semiconductor layer 4. The electron barrier layer 42 may be a layer having a smaller thickness than the first p-side composition gradient layer 411.

The electron barrier layer 42 may have a multilayer structure. In this case, one or more layers constituting the electron barrier layer 42 have a band gap energy larger than the band gap energy of any layer included in the first portion 41. The electron barrier layer 42 may be a composition gradient layer. The electron barrier layer 42 may be, for example, a composition gradient layer in which the composition is changed such that the band gap energy is reduced upward in the electron barrier layer 42. When the first portion 41 or the electron barrier layer 42 includes a superlattice layer, the magnitudes are compared using the average band gap energy of the superlattice layer instead of the band gap energy of each layer included in the superlattice layer. The electron barrier layer 42 is made of, for example, AlGaN. When the electron barrier layer 42 is AlGaN, the Al composition ratio thereof may be in a range of 0.08 to 0.5. The thickness of the electron barrier layer 42 can be 4 nm or more, and can be 100 nm or more, for example.

### (Second Portion 43)

The second portion 43 includes one or more p-type semiconductor layers each containing a p-type impurity. The second portion 43 may be disposed in contact with an upper surface of the electron barrier layer. The p-type impurity concentration of the p-type semiconductor layer included in the second portion 43 can be 1 x 10¹⁸/cm³ or more, and can be 1 x 10²²/cm³ or less, for example. As described above, the drive voltage can be reduced by making the second portion 43 thinner, and thus the thickness of the second portion 43 is preferably 260 nm or less. The thickness of the second portion 43 can be 10 nm or more. The second portion 43 may include an undoped layer. The second portion 43 in its entirety preferably contains a p-type impurity. Thus, a resistance of the second portion 43 can be reduced compared with the case of including the undoped layer. In the case of a superlattice layer, the average p-type impurity concentration thereof can be regarded as the p-type impurity concentration of the superlattice layer, and thus in the case in which the second portion 43 includes a superlattice layer, the superlattice layer may have a layered structure of the undoped layer and the p-type impurity-containing layer.

The thickness of the second portion 43 may be smaller than the thickness of the first portion 41. When the first portion 41 is relatively thick, the peak of light intensity can be kept away from the p-type impurity-containing layer, and the loss due to free carrier absorption in the p-type impurity-containing layer can be reduced. Thus, efficiency such as the slope efficiency of the semiconductor laser element 100 can be improved. In addition, when the second portion 43 is relatively thin, the drive voltage of the semiconductor laser element 100 can be reduced, and the efficiency can be improved. The reason why the voltage is decreased by making the thickness of the portion containing the p-type impurity thinner is that, in a nitride semiconductor, a p-type impurity such as Mg has a lower activation rate than an n-type impurity such as Si and the p-type impurity-containing layer has a relatively high resistance. Although the first portion 41 is undoped, since the first portion 41 is located between the electron barrier layer 42 and the active layer 3, the first portion 41 tends to exhibit n-type conductivity rather than complete insulation, due to factors such as the overflow of electrons. From these facts, it is considered that the drive voltage is lowered by making the thickness of the second portion 43 containing the p-type impurity and having a relatively high resistance thinner, and an increase in the drive voltage can be inhibited by increasing the thickness of the first portion 41, which is undoped. Since the first portion 41 is relatively thick, the lower end of the ridge 4a is preferably provided in the first portion 41. Thus, optical confinement in the lateral direction can be enhanced.

The second portion 43 may include a lower p-type semiconductor layer and an upper p-type semiconductor layer. The upper p-type semiconductor layer constitutes the upper surface of the ridge 4a. That is, the upper p-type semiconductor layer is the uppermost layer of the second portion 43. The upper p-type semiconductor layer functions as a p-side contact layer. The lower p-type semiconductor layer is disposed between the upper p-type semiconductor layer and the electron barrier layer 42, and has a band gap energy larger than a band gap energy of the upper p-type semiconductor layer.

The lower p-type semiconductor layer is made of, for example, AlGaN. The upper p-type semiconductor layer is made of, for example, GaN. The lower p-type semiconductor layer may function as a p-side cladding layer. The lower p-type semiconductor layer may be a p-type GaN layer, and thus the resistance of the second portion 43 can be further reduced. In this case, the p electrode is preferably made of a material that functions as a cladding layer made of ITO or the like. The thickness of the upper p-type semiconductor layer can be, for example, in a range of 5 nm to 30 nm. The thickness of the lower p-type semiconductor layer can be, for example, in a range of 1 nm to 260 nm. The lower p-type semiconductor layer has a larger thickness than, for example, the electron barrier layer 42. In this case, in order to reduce the free carrier absorption loss, the p-type impurity concentration of the lower p-type semiconductor layer is preferably lower than the p-type impurity concentration of the electron barrier layer 42.

### (Insulating Film 5, n Electrode 8, p Electrode 6, and p-Side Pad Electrode 7)

The insulating film 5 can be formed of, for example, a single-layer film or a multilayer film of an oxide or a nitride of Si, Al, Zr, Ti, Nb, Ta, or the like. The n electrode 8 is provided on, for example, substantially the entire lower surface of the n-type substrate 1. The p electrode 6 is provided on the upper surface of the ridge 4a. When a width of the p electrode 6 is narrow, the p-side pad electrode 7 having a width wider than the p electrode 6 may be provided on the p electrode 6, and a wire or the like may be connected to the p-side pad electrode 7. Examples of a material of each electrode include a single-layer film or a multilayer film of a metal such as Ni, Rh, Cr, Au, W, Pt, Ti, or Al, an alloy thereof, a conductive oxide including at least one selected from Zn, In, and Sn, or the like. Examples of the conductive oxide include indium tin oxide (ITO), indium zinc oxide (IZO), and gallium-doped zinc oxide (GZO).
The thicknesses of the electrodes each generally only need to be a thickness such that the electrodes can function as electrodes of the semiconductor element. Examples of the thicknesses include a range of 0.05 µm to 2 µm.

The p electrode 6 is preferably a transparent conductive film having a refractive index smaller than a refractive index of the active layer 3. Thus, the p electrode 6 can function as the cladding layer. Furthermore, the p electrode 6 is preferably a transparent conductive film having a refractive index smaller than a refractive index of the second portion 43. Thus, the optical confinement effect can be further obtained. When the p-side cladding layer is provided in the second portion 43, for example, an AlGaN layer having a relatively high Al composition ratio and doped with a p-type impurity is provided as the p-side cladding layer. The higher the Al composition ratio is, the higher the resistance tends to be. When the p electrode 6 functions as the cladding layer, the p-side cladding layer need not be provided in the second portion 43, or even when the p-side cladding layer is provided, the Al composition ratio thereof can be reduced. Thus, the resistance can be reduced, and the drive voltage of the semiconductor laser element 100 can be reduced. Examples of the p electrode 6 functioning as the cladding layer include the p electrode 6 made of ITO.

### (Manufacturing Method)

A method for manufacturing the semiconductor laser element 100 according to the embodiment includes, for example, the following first to fifth steps. First step is a step of forming the n-side semiconductor layer 2 on the substrate 1. Second step is a step of forming the active layer 3 on the n-side semiconductor layer 2. Third step is a step of forming, so as to be undoped, the first portion 41 including one or more semiconductor layers on the upper surface of the active layer 3. Fourth step is a step of forming the electron barrier layer 42 on the upper surface of the first portion 41 by being doped with a p-type impurity. Fifth step is a step of forming, on the upper surface of the electron barrier layer 42, the second portion 43 including one or more p-type semiconductor layers formed by being doped with a p-type impurity. In third step, the layers constituting the first portion 41 are formed in order from bottom to top. The method for manufacturing the semiconductor laser element 100 may further include sixth step of forming the ridge 4a protruding upward by removing a part of the p-side semiconductor layer 4 including the first portion 41, the electron barrier layer 42, and the second portion 43. The effects and preferable configurations of the layers and the like obtained by the steps are as described above.

### (First Example)

In a first example, the semiconductor laser element 100 was produced. An MOCVD apparatus was used to produce an epitaxial wafer to be the semiconductor laser element 100. As raw materials, trimethylgallium (TMG), triethylgallium (TEG), trimethylaluminum (TMA), trimethylindium (TMI), ammonia (NH₃), a silane gas, and bis(cyclopentadienyl)magnesium (Cp₂Mg) were used as appropriate.

The n-side semiconductor layer 2, the active layer 3, and the p-side semiconductor layer 4 were grown in this order on an n-type GaN substrate (substrate 1) having a +c-plane as an upper surface.

The n-side semiconductor layer 2 was formed including, in order from the n-type GaN substrate side, a Si-doped Al_{0.016}Ga_{0.984}N layer having a thickness of 1.5 µm, a Si-doped In_{0.05}Ga_{0.95}N layer having a thickness of 150 nm, a Si-doped Al_{0.072}Ga_{0.928}N layer having a thickness of 900 nm (n-type semiconductor layer 22), a Si-doped GaN layer having a thickness of 3500 nm (n-side intermediate portion 23), and an n-side composition gradient layer 21 grown by substantially monotonically increasing the In composition with GaN as a Si-doped starting end having a thickness of 200 nm and the In_{0.05}Ga_{0.95}N as a terminating end.

The active layer 3 was formed including, in order from the n-type GaN substrate side, a Si-doped GaN layer, an undoped In composition gradient layer, an undoped In_{0.2}Ga_{0.8}N layer, and an undoped GaN layer.

The p-side semiconductor layer 4 was formed including, in order from the n-type GaN substrate side, the undoped first p-side composition gradient layer 411 having a thickness of 200 nm, the undoped intermediate layer 413 having a thickness of 50 nm, the undoped second p-side composition gradient layer 412 having a thickness of 70 nm, the intermediate layer 414 made of undoped Al_{0.045}Ga_{0.955}N and having a thickness of 130 nm, the electron barrier layer 42 made of Mg-doped AlGaN and having a thickness of 10 nm, the lower p-type semiconductor layer made of Mg-doped AlGaN and having a thickness of 100 nm, and the upper p-type semiconductor layer made of Mg-doped GaN and having a thickness of 18 nm. In the first p-side composition gradient layer 411, the starting end of growth was In_{0.05}Ga_{0.95}N, and the terminating end of growth was GaN. In the second p-side composition gradient layer 412, the starting end of growth was AlGaN having an Al composition ratio of 1% or less, and the terminating end of growth was Al_{0.045}Ga_{0.955}N.

Then, the epitaxial wafer on which the above-described layers were formed was taken out from the MOCVD apparatus, the ridge 4a, the insulating film 5, the p electrode 6, the p-side pad electrode 7, and the n electrode 8 were formed, a reflective film was formed on each of the light-emitting end surface and the light-reflecting end surface, and the epitaxial wafer was subjected to singulation to obtain the semiconductor laser elements 100. The depth of the ridge 4a was about 270 nm. That is, the ridge 4a was formed such that the lower end thereof was located in the second p-side composition gradient layer 412. An ITO film having a thickness of 200 nm was formed as the p electrode 6. The peak wavelength of the laser light emitted by the semiconductor laser element 100 according to the first example was about 455 nm.

### (SIMS Analysis)

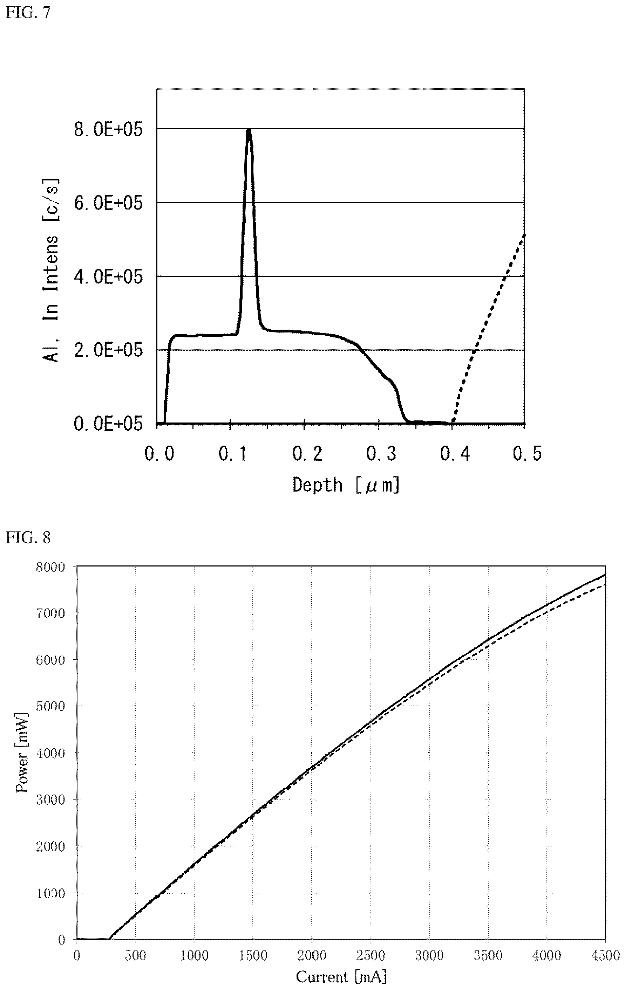

FIG. 7 shows a result of SIMS analysis performed on the wafer on which the p-side semiconductor layer 4 similar to that of the first example was grown and the growth was stopped before the ridge 4a and the like were formed. In FIG. 7, a broken line indicates a detection amount of In, and a solid line indicates a detection amount of Al. A vertical axis and a horizontal axis in FIG. 7 are linear scales. It was confirmed from FIG. 7 that the intermediate layer 414 was formed between the first p-side composition gradient layer 411 and the second p-side composition gradient layer 412. In FIG. 7, the line indicating the detection amount of In and the line indicating the detection amount of Al intersect with each other at the lower end (the right end in the graph) of the intermediate layer 414, and Al is detected in more than half of the intermediate layer 414.

### (Second Example)

The n-side semiconductor layer 2, the active layer 3, and the p-side semiconductor layer 4 were grown in this order on the n-type GaN substrate (substrate 1) having the +c-plane as the upper surface.

The n-side semiconductor layer 2 was formed including, in order from the n-type GaN substrate side, a Si-doped Al_{0.018}Ga_{0.982}N layer having a thickness of 1.25 µm, a Si-doped Al_{0.08}Ga_{0.92}N layer having a thickness of 250 nm, a Si-doped In_{0.04}Ga_{0.96}N layer having a thickness of 150 nm, a Si-doped GaN layer having a thickness of 10 nm, a Si-doped Al_{0.08}Ga_{0.92}N layer having a thickness of 650 nm (n-type semiconductor layer 22), a Si-doped GaN layer having a thickness of 200 nm (n-side intermediate portion 23), and an undoped In_{0.03}Ga_{0.97}N layer having a thickness of 230 nm.

The active layer 3 was formed including, in this order from the n-type GaN substrate side, a Si-doped GaN layer, a Si-doped In_{0.05}Ga_{0.95}N layer, a Si-doped GaN layer, an undoped In_{0.25}Ga_{0.75}N layer, an undoped GaN layer, an undoped In_{0.25}Ga_{0.75}N layer, and an undoped GaN layer.

The p-side semiconductor layer 4 was formed including, in order from the n-type GaN substrate side, the undoped first p-side composition gradient layer 411 having a thickness of 180 nm, the undoped intermediate layer 413 having a thickness of 50 nm, the undoped second p-side composition gradient layer 412 having a thickness of 100 nm, the intermediate layer 414 made of undoped Al_{0.04}Ga_{0.96}N and having a thickness of 200 nm, the electron barrier layer 42 made of Mg-doped AlGaN and having a thickness of 10.9 nm, the lower p-type semiconductor layer made of Mg-doped AlGaN and having a thickness of 100 nm, and the upper p-type semiconductor layer made of Mg-doped GaN and having a thickness of 18 nm. In the first p-side composition gradient layer 411, the starting end of growth was In_{0.05}Ga_{0.95}N, and the terminating end of growth was GaN. In the second p-side composition gradient layer 412, the starting end of growth was AlGaN having an Al composition ratio of 1% or less, and the terminating end of growth was Al_{0.04}Ga_{0.96}N.

Then, the epitaxial wafer on which the above-described layers were formed was taken out from the MOCVD apparatus, the ridge 4a, the insulating film 5, the p electrode 6, the p-side pad electrode 7, and the n electrode 8 were formed, a reflective film was formed on each of the light-emitting end surface and the light-reflecting end surface, and the epitaxial wafer was subjected to singulation to obtain the semiconductor laser elements 100. The depth of the ridge 4a was about 270 nm. That is, the ridge 4a was formed such that the lower end thereof was located in the intermediate layer 414. An ITO film having a thickness of 200 nm was formed as the p electrode 6. The peak wavelength of the laser light emitted by the semiconductor laser element 100 according to the second example was about 527 nm.

### (Third Example)

The semiconductor laser element 100 according to a third example was produced as in the second example except for the following points. The last two layers in the n-side semiconductor layer 2 were a Si-doped GaN layer having a thickness of 250 nm (n-side intermediate portion 23) and an undoped In_{0.03}Ga_{0.97}N layer having a thickness of 180 nm. In the p-side semiconductor layer 4, the thickness of the second p-side composition gradient layer 412 was 300 nm and the intermediate layer 414 was omitted. The undoped intermediate layer 413 having a thickness of 50 nm was also employed in this example. The depth of the ridge 4a was also about 270 nm in this example. That is, the ridge 4a was formed such that the lower end thereof was located in the second p-side composition gradient layer 412. The peak wavelength of the laser light emitted by the semiconductor laser element 100 according to the third example was 527 nm.

### (First Comparative Example)

The semiconductor laser element according to a first comparative example was produced in a manner similar to that of the semiconductor laser element 100 according to the first example except that the intermediate layer 413 and the second p-side composition gradient layer 412 were not formed, and an undoped GaN layer having a thickness of 120 nm was formed at that position. The depth of the ridge 4a was also about 270 nm in this comparative example. That is, the ridge 4a was formed such that the lower end thereof was located on the undoped GaN layer having a thickness of 120 nm. The peak wavelength of the laser light emitted by the semiconductor laser element according to the first comparative example was 455 nm.

### (Second Comparative Example)

The semiconductor laser element according to a second comparative example was produced as in the second example except for the following points. The last two layers in the n-side semiconductor layer 2 were a Si-doped GaN layer having a thickness of 250 nm and an undoped In_{0.03}Ga_{0.97}N layer having a thickness of 180 nm. In the p-side semiconductor layer 4, the second p-side composition gradient layer 412 was not formed, and an undoped GaN layer having a thickness of 150 nm was formed at that position. The peak wavelength of the laser light emitted by the semiconductor laser element according to the second comparative example was 527 nm.

### (I-L Characteristics)

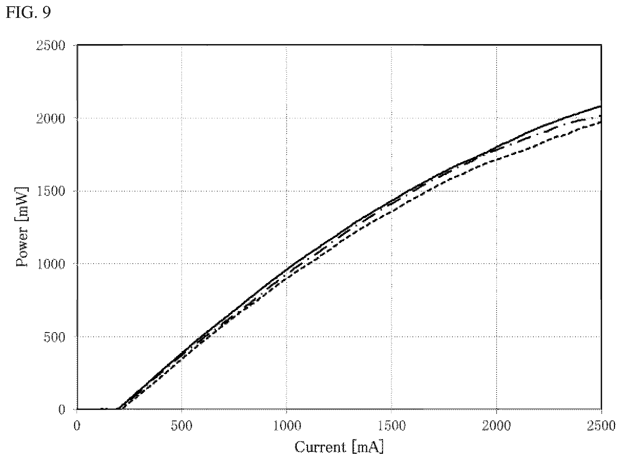

FIG. 8 shows the I-L characteristics of the semiconductor laser elements of the first example and the first comparative example. In the graph in FIG. 8, a horizontal axis represents current, and a vertical axis represents optical output. In FIG. 8, a solid line indicates the first example, and a broken line indicates the first comparative example. FIG. 9 shows I-L characteristics of the semiconductor laser elements of the second example, the third example, and the second comparative example. In the graph in FIG. 9, a horizontal axis represents current, and a vertical axis represents optical output. In FIG. 9, a solid line indicates the second example, an alternate long and short dash line indicates the third example, and a broken line indicates the second comparative example. As shown in FIGS. 8 and 9, it was confirmed that by providing the first p-side composition gradient layer 411, the intermediate layer 413, and the second p-side composition gradient layer 412, the slope efficiency was improved, and the optical output was improved. This is considered to be an effect obtained by reducing the loss of carriers in the p-side semiconductor layer 4.

The description in the present specification discloses the following technical aspects.
(Aspect 1) A semiconductor laser element comprising:
   an n-side semiconductor layer, an active layer, and a p-side semiconductor layer, the n-side semiconductor layer, the active layer, and the p-side semiconductor layer being made of a nitride semiconductor, wherein
   the p-side semiconductor layer comprises, in this order in an upward direction,
      a first portion comprising one or more semiconductor layers and being undoped,
      an electron barrier layer having a band gap energy larger than a band gap energy of the first portion and containing a p-type impurity, and
      a second portion comprising one or more p-type semiconductor layers containing a p-type impurity, and
   the first portion comprises
      a first p-side composition gradient layer made of InₓGa₁₋ₓN and having an In composition ratio x decreasing in a range of 0 to less than 1 upward in the first p-side composition gradient layer,
      a second p-side composition gradient layer disposed between the first p-side composition gradient layer and the electron barrier layer, made of Al_{y}Ga_{1-y}N, and having an Al composition ratio y increasing in a range of more than 0 to less than 1 upward in the second p-side composition gradient layer, and
      an intermediate layer disposed between the first p-side composition gradient layer and the second p-side composition gradient layer, made of Al_{z}Ga_{1-z}N, and having an Al composition ratio z in a range of more than 0 to less than y.
(Aspect 2) The semiconductor laser element according to Aspect 1, wherein
   a composition of the first p-side composition gradient layer is changed at a first change rate such that a band gap energy is increased upward in the first p-side composition gradient layer, and
   a composition of the second p-side composition gradient layer is changed at a second change rate lower than the first change rate such that a band gap energy is increased upward in the second p-side composition gradient layer.
(Aspect 3) The semiconductor laser element according to Aspect 1 or 2, wherein the Al composition ratio y at an upper end of the second p-side composition gradient layer is 0.1 or less.
(Aspect 4) The semiconductor laser element according to any one of Aspects 1 to 3, wherein a thickness of the second p-side composition gradient layer is 2 nm or more.
(Aspect 5) The semiconductor laser element according to any one of Aspects 1 to 4, wherein the Al composition ratio z of the intermediate layer is in a range of more than 0 to 0.01.
(Aspect 6) The semiconductor laser element according to any one of Aspects 1 to 5, wherein the Al composition ratio y at a lower end of the second p-side composition gradient layer is in a range of more than the Al composition ratio z of the intermediate layer to 0.05.
(Aspect 7) The semiconductor laser element according to any one of Aspects 1 to 6, wherein
   the intermediate layer is a first intermediate layer, and
   the first portion comprises a second intermediate layer disposed between the second p-side composition gradient layer and the electron barrier layer and having a band gap energy equal to a band gap energy of an upper end of the second p-side composition gradient layer or a band gap energy between the band gap energy of the upper end of the second p-side composition gradient layer and the band gap energy of the electron barrier layer.
(Aspect 8) The semiconductor laser element according to Aspect 7, wherein a ratio of a thickness of the second p-side composition gradient layer to a sum of the thickness of the second p-side composition gradient layer and a thickness of the second intermediate layer is 0.5 or less.
(Aspect 9) The semiconductor laser element according to any one of Aspects 1 to 8, wherein
   the n-side semiconductor layer comprises
      an n-side composition gradient layer disposed in contact with a lower surface of the active layer and having a composition changed such that a band gap energy is increased downward in the n-side composition gradient layer, and
      an n-type semiconductor layer disposed below the n-side composition gradient layer, having a band gap energy larger than a band gap energy of any layer included in the first portion of the p-side semiconductor layer, and containing an n-type impurity, and
      an n-side intermediate portion disposed between the n-side composition gradient layer and the n-type semiconductor layer, and
   a distance from the n-side composition gradient layer to the n-type semiconductor layer is larger than a distance from the first p-side composition gradient layer to the electron barrier layer.
(Aspect 10) The semiconductor laser element according to any one of Aspects 1 to 9, wherein
   the active layer comprises
      an n-side barrier layer,
      a p-side barrier layer,
      a plurality of well layers located between the n-side barrier layer and the p-side barrier layer, the plurality of well layers comprising a first well layer and a second well layer, and
      an intermediate barrier layer located between the first well layer and the second well layer, and
   a thickness of the intermediate barrier layer is smaller than a thickness of the p-side barrier layer.

### Reference Characters List

100 Semiconductor laser element
1 Substrate
2 n-side semiconductor layer
   21 n-side composition gradient layer
   22 n-type semiconductor layer
   23 n-side intermediate portion
   231 Intermediate layer
   232 Composition gradient layer
   233 Intermediate layer
3, 3A Active layer
   31 n-side barrier layer
   32 Well layer
   33 p-side barrier layer
   34 Intermediate barrier layer
4 p-side semiconductor layer
   41 First portion
   411 First p-side composition gradient layer
   411a, 411b, 411c, 411y, 411z Sublayer
   412 Second p-side composition gradient layer
   412a, 412b, 412c, 412y, 412z Sublayer
   413 Intermediate layer
   414 Intermediate layer
   42 Electron barrier layer
   43 Second portion
4a Ridge
5 Insulating film
6 p electrode
7 p-side pad electrode
8 n electrode

## Claims

1. A semiconductor laser element comprising:
an n-side semiconductor layer, an active layer, and a p-side semiconductor layer, the n-side semiconductor layer, the active layer, and the p-side semiconductor layer being made of a nitride semiconductor, wherein
the p-side semiconductor layer comprises, in this order in an upward direction,
a first portion comprising one or more semiconductor layers and being undoped,
an electron barrier layer having a band gap energy larger than a band gap energy of the first portion and containing a p-type impurity, and
a second portion comprising one or more p-type semiconductor layers containing a p-type impurity, and
the first portion comprises
a first p-side composition gradient layer made of InₓGa₁₋ₓN and having an In composition ratio x decreasing in a range of 0 to less than 1 upward in the first p-side composition gradient layer,
a second p-side composition gradient layer disposed between the first p-side composition gradient layer and the electron barrier layer, made of Al_{y}Ga_{1-y}N, and having an Al composition ratio y increasing in a range of more than 0 to less than 1 upward in the second p-side composition gradient layer, and
an intermediate layer disposed between the first p-side composition gradient layer and the second p-side composition gradient layer, made of Al_{z}Ga_{1-z}N, and having an Al composition ratio z in a range of more than 0 to less than y.

2. The semiconductor laser element according to claim 1, wherein
a composition of the first p-side composition gradient layer is changed at a first change rate such that a band gap energy is increased upward in the first p-side composition gradient layer, and
a composition of the second p-side composition gradient layer is changed at a second change rate lower than the first change rate such that a band gap energy is increased upward in the second p-side composition gradient layer.

3. The semiconductor laser element according to claim 1 or 2, wherein the Al composition ratio y at an upper end of the second p-side composition gradient layer is 0.1 or less.

4. The semiconductor laser element according to any one of claims 1 to 3, wherein a thickness of the second p-side composition gradient layer is 2 nm or more.

5. The semiconductor laser element according to any one of claims 1 to 4, wherein the Al composition ratio z of the intermediate layer is in a range of more than 0 to 0.01.

6. The semiconductor laser element according to any one of claims 1 to 5, wherein the Al composition ratio y at a lower end of the second p-side composition gradient layer is in a range of more than the Al composition ratio z of the intermediate layer to 0.05.

7. The semiconductor laser element according to any one of claims 1 to 6, wherein
the intermediate layer is a first intermediate layer, and
the first portion comprises a second intermediate layer disposed between the second p-side composition gradient layer and the electron barrier layer and having a band gap energy equal to a band gap energy of an upper end of the second p-side composition gradient layer or between the band gap energy of the upper end of the second p-side composition gradient layer and the band gap energy of the electron barrier layer.

8. The semiconductor laser element according to claim 7, wherein a ratio of a thickness of the second p-side composition gradient layer to a sum of the thickness of the second p-side composition gradient layer and a thickness of the second intermediate layer is 0.5 or less.

9. The semiconductor laser element according to any one of claims 1 to 8, wherein
the n-side semiconductor layer comprises
an n-side composition gradient layer disposed in contact with a lower surface of the active layer and having a composition changed such that a band gap energy is increased downward in the n-side composition gradient layer, and
an n-type semiconductor layer disposed below the n-side composition gradient layer, having a band gap energy larger than a band gap energy of any layer included in the first portion of the p-side semiconductor layer, and containing an n-type impurity, and
an n-side intermediate portion disposed between the n-side composition gradient layer and the n-type semiconductor layer, and
a distance from the n-side composition gradient layer to the n-type semiconductor layer is larger than a distance from the first p-side composition gradient layer to the electron barrier layer.

10. The semiconductor laser element according to any one of claims 1 to 9, wherein
the active layer comprises
an n-side barrier layer,
a p-side barrier layer,
a plurality of well layers located between the n-side barrier layer and the p-side barrier layer, the plurality of well layers comprising a first well layer and a second well layer, and
an intermediate barrier layer located between the first well layer and the second well layer, and
a thickness of the intermediate barrier layer is smaller than a thickness of the p-side barrier layer.
